**Europäisches Patentamt**

**European Patent Office**

**Office européen des brevets**

(19)

(11) Numéro de publication : **0 596 789 A1**

# (12) DEMANDE DE BREVET EUROPEEN

(21) Numéro de dépôt : **93402684.0**

(22) Date de dépôt : **02.11.93**

(51) Int. Cl.⁵ : **G01R 31/36**

(30) Priorité : **04.11.92 FR 9213231**

(43) Date de publication de la demande :
**11.05.94 Bulletin 94/19**

(84) Etats contractants désignés :
**DE ES GB IT**

(71) Demandeur : **Société Anonyme dite: REGIE NATIONALE DES USINES RENAULT
34, quai du Point du Jour
F-92109 Boulogne Billancourt (FR)**

(72) Inventeur : **André, Bernard
7, Boulevard Marcel Pourtout
F-92500 Rueil-Malmaison (FR)**
Inventeur : **Collinet, Jean-Christophe
31, rue de Lacroix Saint-Simon
F-75020 Paris (FR)**
Inventeur : **Malvot, Gérard
107, ruelle à l'âne
F-49400 Bagneux Saumur (FR)**

(54) **Procédé et dispositif de mesure de la charge d'une batterie d'accumulateurs.**

(57) Afin de mesurer l'état de charge d'une batterie en fonction de sa force électromotrice (E) et de sa température (T), le procédé consiste

— à déterminer une première fonction (f1) de la température (T) établissant une relation entre ladite température (T) et une valeur de charge maximum ($Q_T$) représentative de la quantité maximale d'électricité emmagasinée à cette température (T) dans la batterie (1),

— à déterminer une seconde fonction (f2) de la force électromotrice (E) établissant une relation entre ladite force électromotrice (E) et une valeur de décharge (D) représentative de la quantité d'électricité qui doit sortir de la batterie (1) pour la faire passer d'un état de charge maximum ($Q_T$) à un état de charge correspondant à ladite force électromotrice,

— à mesurer ladite température (T) et ladite force électromotrice (E) et

— à calculer la différence (Q) entre lesdites première et seconde fonctions (f1, f2) appliquées respectivement auxdites température (T) et force électromotrice (E) mesurées.

Application notamment pour évaluer la durée maximale de stationnement.

FIG. 4

EP 0 596 789 A1

L'invention concerne principalement un procédé pour mesurer l'état de charge d'une batterie d'accumulateurs, c'est-à-dire la quantité d'électricité qu'elle est capable de restituer.

Ce procédé peut s'appliquer en particulier aux batteries installées sur un véhicule automobile, telles que les batteries de démarrage pour moteur à combustion interne. Dans ce cas, la connaissance de l'état de charge par le conducteur lui permet d'évaluer les potentialités ou les défauts du système de démarrage du véhicule. D'autre part, en évaluant le courant débité par la batterie pendant les périodes de repos du véhicule, l'état de charge permet de calculer la durée maximale de stationnement.

Une première méthode pour mesurer l'état de charge consiste à mesurer la densité de l'électrolyte. Cette solution est cependant délicate et difficile à mettre en oeuvre de façon non manuelle. De plus, la mesure de densité devrait être effectuée sur chacun des accumulateurs (éléments) pour rendre compte de l'état de la batterie.

Une autre solution connue consiste à évaluer l'état de charge à partir d'une mesure de la force électromotrice de la batterie. Cependant, la force électromotrice n'est pas le seul paramètre dont dépend la charge. En particulier la température de l'électrolyte a une influence non négligeable sur la charge.

Une autre solution connue consiste à mesurer en permanence l'intégrale par rapport au temps des courants de charge et des courants débités par la batterie et à en déduire l'état de charge instantané, connaissant l'état de charge lors de l'installation initiale de la batterie sur le véhicule. Cependant, l'intégration des courants pose des problèmes de dérive dans le temps qui nuisent à la précision de la mesure.

Ainsi, pour des raisons de facilité de mise en oeuvre par un système de mesure automatique, les méthodes basées sur la mesure de la force électromotrice sont préférables. Cependant, jusqu'à présent on interprétait la force électromotrice comme une grandeur représentative de l'état de charge et on établissait une loi liant la charge à la force électromotrice.

En réalité, la force électromotrice n'est pas directement représentative de l'état de charge mais au contraire de la quantité d'électricité qui est sortie de la batterie depuis son état de charge maximum. Sachant d'autre part qu'à une température donnée, la quantité maximale d'électricité qu'une batterie peut fournir depuis son état de charge maximale ne dépend pratiquement que de la température et du type de batterie utilisé, il est possible de calculer l'état de charge instantané à une température donnée en effectuant la différence entre la capacité maximale de la batterie à cette température et la quantité d'électricité qui est sortie de la batterie.

Dans le but de mesurer l'état de charge d'une batterie d'accumulateur de façon simple et suffisamment précise, l'invention exploite les observations précédentes.

Plus précisément, l'invention a pour objet un procédé de mesure de l'état de charge d'une batterie d'accumulateurs à partir de mesures de la force électromotrice et de la température de ladite batterie, caractérisé en ce qu'il consiste

- à déterminer une première fonction de la température établissant une relation entre ladite température et une valeur de charge maximum représentative de la quantité maximale d'électricité emmagasinée à cette température dans la batterie,
- à déterminer une seconde fonction de la force électromotrice établissant une relation entre ladite force électromotrice et une valeur de décharge représentative de la quantité d'électricité qui doit sortir de la batterie pour la faire passer d'un état de charge maximum à un état de charge correspondant à ladite force électromotrice,
- à mesurer ladite température et ladite force électromotrice et
- à calculer la différence entre lesdites première et seconde fonctions appliquées respectivement auxdites température et force électromotrice mesurées.

Contrairement aux solutions connues antérieurement, ce procédé utilise seulement deux fonctions d'une seule variable (force électromotrice ou température), ce qui permet de réduire considérablement le nombre de données nécessaire pour exprimer la relation entre la charge et les deux variables. La détermination précise des deux fonctions mentionnées ci-dessus peut être effectuée expérimentalement pour chaque type de batterie utilisable dans les véhicules. En réalité, ces fonctions peuvent être assimilées avec une bonne approximation à des fonctions linéaires, du moins sur une large plage de variations. Le choix de fonctions linéaires permet de simplifier la réalisation dans le cadre d'un dispositif de mesure automatique. Pour la même raison, il est avantageux que ces fonctions expriment des quantités d'électricité pouvant être emmagasinées dans la batterie, indépendamment du type de batterie considéré.

La mesure de la force électromotrice peut être effectuée de diverses façons. On peut par exemple évaluer la résistance interne de la batterie et mesurer en cours d'utilisation la tension à ses bornes et le courant qu'elle débite. L'application de la Loi d'Ohm permet en première approximation d'obtenir la force électromotrice. Cette méthode n'est cependant pas entièrement satisfaisante car la résistance interne est difficile à évaluer et, dans le cas d'une batterie sur véhicule, les mesures de tension sont perturbées notamment par le fonctionnement de l'alternateur.

Pour éviter cet inconvénient et selon un aspect supplémentaire de l'invention, le procédé est caractérisé en ce que ladite batterie étant installée dans un véhicule automobile, ladite mesure de force électromotrice est effectuée à partir de mesures de tension aux bornes de la batterie pendant les périodes de repos du véhicule.

Afin de tenir compte du fait que sur un véhicule le temps de repos nécessaire à l'obtention de la force électromotrice et le temps de repos disponible sont variables, le procédé est en outre caractérisé en ce que lesdites mesures de tension sont effectuées à des instants successifs puis enregistrées sous forme de grandeurs numériques dans un espace mémoire adressé selon le mode "premier entré-premier sorti" et en ce que lesdites grandeurs numériques enregistrées sont utilisées pour calculer par une méthode statistique une valeur représentative de ladite force électromotrice.

La méthode évoquée ci-dessus peut cependant donner un résultat erroné dans le cas d'une batterie dont un ou plusieurs éléments seraient défectueux. Généralement, le vieillissement d'une batterie se caractérise d'abord par la diminution de la capacité d'un de ses éléments. Cette diminution de capacité se traduit par une force électromotrice de l'élément défectueux inférieure à celle d'un élément en bon état. Ainsi, la quantité d'électricité qu'une batterie peut fournir est conditionnée par la quantité d'électricité que peut fournir son élément le plus faible.

Aussi pour tenir compte des observations précédentes, le procédé selon l'invention est en outre caractérisé en ce que ladite batterie étant organisée en deux groupes d'accumulateurs montés en série, on calcule une force électromotrice corrigée qui serait celle d'un état fictif de la batterie dont chaque accumulateur aurait une force électromotrice élémentaire minimale, ladite force électromotrice élémentaire minimale étant celle d'un accumulateur particulier d'un second état fictif où les groupes ont respectivement les mêmes forces électromotrices moyennes que celles des groupes de l'état réel et dont ledit accumulateur particulier aurait ladite force électromotrice minimale alors que les autres accumulateurs ont la même force électromotrice et en ce que ladite force électromotrice corrigée est appliquée à ladite seconde fonction pour calculer ladite différence.

Bien sûr, le fait de présumer qu'un seul accumulateur est défectueux correspond au cas le plus défavorable et peut conduire à sous-évaluer la charge réelle de la batterie. Cependant, en pratique, la dégradation d'une batterie par vieillissement se traduit presque toujours d'abord par la dégradation d'un seul de ses accumulateurs. Par conséquent, le procédé exposé ci-dessus reflète bien la réalité, du moins au cours de la première phase de vieillissement de la batterie.

Etant donné que la force électromotrice est mesurée pendant les périodes de repos, le procédé précédent ne permet pas d'indiquer directement la charge de la batterie lorsque le véhicule est en fonctionnement. Dans ce cas, et selon une caractéristique supplémentaire de l'invention, la mesure de la charge est corrigée en soustrayant une valeur représentative de l'intégrale par rapport au temps du courant en valeur algébrique débité par la batterie.

L'invention a également pour objet l'utilisation du procédé de mesure pour évaluer la durée maximale de stationnement du véhicule. Pour cela, on évalue le courant de décharge moyen le plus probable de la batterie pendant les périodes de repos du véhicule et on calcule cette durée maximale selon la formule $d=(Q-Q_1)/Im$, où:

d est la durée maximale de stationnement,

Q est la charge de la batterie à la température moyenne la plus probable,

$Q_1$ est la charge minimale de la batterie,

Im est le courant de décharge moyen le plus probable pendant les périodes de repos.

L'invention a aussi pour objet un dispositif de mesure pour la mise en oeuvre du procédé dans un véhicule automobile. Plus précisément, le dispositif est caractérisé en ce qu'il comporte une unité de contrôle et un dispositif d'affichage reliés entre eux, en ce que ladite unité de contrôle comprend:

- un capteur de température pour mesurer la température de la batterie,
- au moins un capteur de tension relié aux bornes de la batterie,
- un capteur d'état pour détecter l'état de repos du véhicule,
- une unité de traitement programmable communiquant avec lesdits capteurs et dispositif d'affichage,

et en ce que ladite unité de traitement est programmée de façon à enregistrer les signaux fournis par lesdits capteurs de tension pendant les périodes de repos détectées en réponse aux signaux fournis par ledit capteur d'état et pour calculer ladite différence après chaque période de repos en fonction des signaux enregistrés et de la température.

D'autres aspects et avantages du procédé et du dispositif selon l'invention seront exposés plus en détail dans la suite de la description en référence aux figures.

- La figure 1 est un diagramme représentant les variations de la décharge en fonction de la force électromotrice de la batterie;
- La figure 2 est un diagramme représentant les variations de la capacité maximale de la batterie en fonction de sa température;
- La figure 3 illustre le principe utilisé pour évaluer l'état de charge d'une batterie munie d'un point milieu;
- La figure 4 représente les différentes étapes pour calculer l'état de charge;
- La figure 5 représente une variante de la figure 4;
- La figure 6 représente un dispositif pour la mise en oeuvre du procédé selon l'invention;
- La figure 7 représente une unité de traitement du dispositif de la figure 6;
- La figure 8 représente un sous-ensemble du circuit d'alimentation de l'unité de traitement;
- La figure 9 est un diagramme statistique servant à évaluer la force électromotrice pendant les périodes de repos;
- La figure 10 montre l'organisation de l'espace mémoire de l'unité de traitement affecté aux paramètres mesurés.

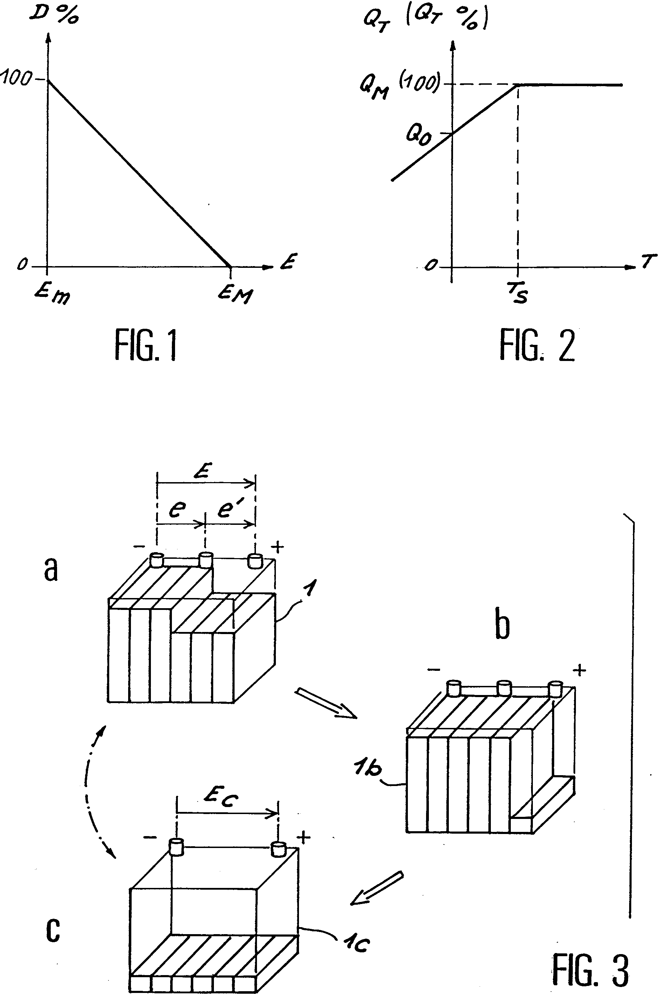

La figure 1 est une représentation graphique d'un exemple de fonction f2 exprimant la relation entre la décharge D de la batterie depuis son état de charge maximale et sa force électromotrice E. Selon cet exemple, la fonction f2 est une fonction linéaire décroissante de E compris entre deux valeurs minimale et maximale $E_m$ et $E_M$ et qui exprime la décharge en pourcentage D% de la quantité maximum d'électricité $Q_M$ pouvant être emmagasinée dans la batterie. Le fait d'utiliser une fonction f2 exprimant une quantité d'électricité rapportée à la quantité maximum permet de s'affranchir d'un paramètre supplémentaire lié au type de batterie utilisé.

Dans le cas par exemple d'une batterie au plomb, la pente de la courbe correspond à une variation de 100% de la décharge pour une variation de 1 volt environ de la force électromotrice.

Le diagramme de la figure 2 est la représentation d'une fonction f1 exprimant la relation entre la charge maximale $Q_T$ et la température T. Comme précédemment, la fonction f1 représente avantageusement une valeur de charge rapportée à la charge maximale $Q_M$. Comme cela apparaît sur la figure, la fonction f1 est une fonction linéaire croissante de la température T pour des températures inférieures à une valeur de seuil Ts et une fonction constante pour des températures supérieures à cette valeur de seuil.

Toujours dans le cas de l'exemple d'une batterie au plomb, la pente de la partie linéaire de la courbe est environ de 1% par °C, la charge $Q_0$ à 0°C étant de l'ordre de 75% de la valeur maximale $Q_M$. Le seuil de température Ts est environ de 25°C.

Bien entendu, il est toujours possible de choisir des fonctions f1 et f2 plus compliquées de façon à mieux tenir compte du comportement réel de la batterie dans le cas par exemple où l'on utiliserait des batteries autres que celles au plomb.

Ainsi, après avoir défini les fonctions f1 et f2, une simple mesure de la force électromotrice et de la température permet d'obtenir l'état de charge exprimé en pourcentage en soustrayant la valeur de la fonction f2 à celle de la fonction f1.

Ce procédé de mesure peut s'appliquer aussi bien à un accumulateur qu'à une batterie d'accumulateurs montés en série à condition dans ce dernier cas que chaque accumulateur ait les mêmes propriétés. Si par contre un ou plusieurs des accumulateurs de la batterie présentait des faiblesses dues au vieillissement, l'état de charge, c'est-à-dire la quantité d'électricité pouvant être extraite, est limité par l'état de charge de l'accumulateur le plus faible. Ainsi, une solution idéale pour mesurer l'état de charge d'une batterie à plusieurs accumulateurs consiste à mesurer l'état de charge de chaque accumulateur, à déterminer celui dont l'état de charge est le plus faible et à déterminer l'état de charge global de la batterie en l'assimilant à celui de la même batterie dont chaque élément aurait un état de charge égal à l'état de charge de l'élément le plus faible. Cependant, cette solution nécessiterait de prévoir une borne de sortie pour chaque accumulateur intermédiaire. Un compromis à cette solution consiste à ne prévoir qu'une seule borne supplémentaire avantageusement disposée au milieu de la batterie dans le cas où le nombre d'accumulateurs est pair. Cette borne supplémentaire permet de mesurer la force électromotrice au point milieu, ce qui donne une indication d'un déséquilibre pouvant exister entre les accumulateurs situés de part et d'autre de ce point milieu.

La figure 3 est une illustration de la méthode utilisée pour évaluer l'état de charge réel de la batterie par une simple mesure de la force électromotrice de la batterie et de celle mesurée au point milieu. Le schéma (a) représente la batterie réelle 1 comprenant six accumulateurs. Un point milieu permet de mesurer la force électromotrice e des trois premiers accumulateurs, la force électromotrice e' des trois derniers pouvant être mesurée directement ou par différence par rapport à la force électromotrice totale E de la batterie. Dans l'exemple représenté, on a supposé que la force électromotrice e' des trois éléments de droite était inférieure à celle des trois éléments de gauche. Pour évaluer l'état de charge réel de la batterie, on suppose que le déséquilibre des forces électromotrices entre les groupes de droite et de gauche est dû à la défaillance d'un seul des accumulateurs du groupe de droite. Ceci se traduit par une répartition d'états de charge fictifs représentés sur le schéma (b) où cinq des accumulateurs ont un état de charge égal à l'état de charge moyen des accumulateurs du groupe de gauche de la batterie réelle et où un seul des éléments du groupe de droite a un état de charge inférieur et tel que l'état de charge du groupe de droite soit le même que celui de la batterie réelle.

Pour tenir compte du fait que l'accumulateur le plus faible limite la décharge des autres accumulateurs, l'état de charge réel de la batterie correspond au cas illustré par le schéma (c) où chaque accumulateur a un état de charge égal à celui de l'élément le plus faible. Ce second état fictif permet de définir une force électromotrice corrigée Ec correspondante.

Dans le cas général où la batterie serait constituée de deux groupes comportant chacun p accumulateurs montés en série, la force électromotrice corrigée Ec est donnée par la formule:

$$Ec = 2p\ Inf(e,E - e) - 2(p - 1)\ Sup(e,E - e)$$

où:

$Ec$ est la valeur de la force électromotrice corrigée, $e$ est la valeur de la force électromotrice d'un des groupes,

$p$ est le nombre d'éléments par groupe,

$Inf(e,E-e)$ est la plus petite des valeurs $e$ et $E-e$,

$Sup(e,E-e)$ est la plus grande des valeurs $e$ et $E-e$.

Cette méthode donne en fait une valeur corrigée correspondant au cas le plus défavorable où le déséquilibre entre les forces électromotrices $e$ et $e'$ serait dû à un seul des accumulateurs. Ce cas correspond toutefois à une situation réelle la plus probable au début du vieillissement de la batterie car ce vieillissement commence presque toujours par la dégradation d'un seul des accumulateurs.

Une fois que la force électromotrice corrigée $Ec$ a été calculée par la formule précédente, on l'applique à la fonction f2 pour déterminer la décharge de la batterie et grâce à la fonction f1, on en déduit la charge en fonction de la température.

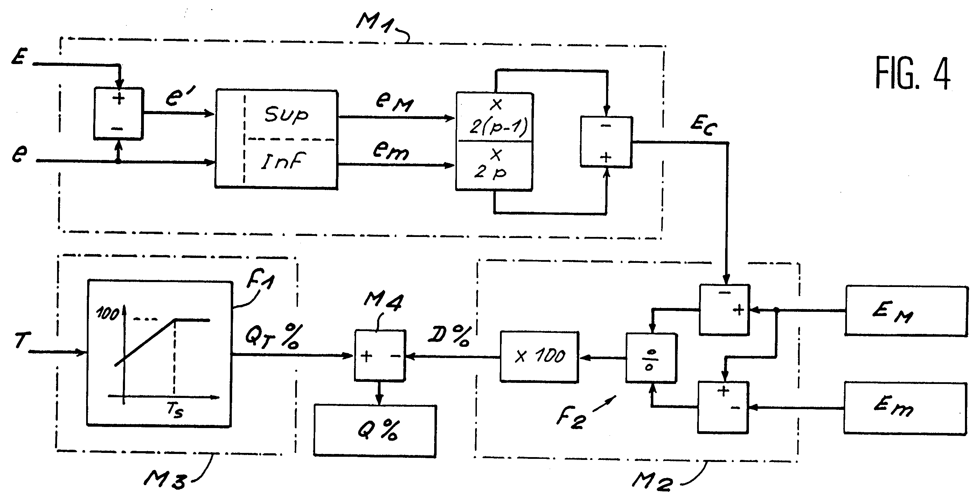

La figure 4 permet d'expliquer plus en détail les différentes étapes du procédé de mesure selon l'invention. Une première étape M1 consiste à calculer la force électromotrice corrigée $E_c$ à partir des mesures des forces électromotrices réelles $E$ et $e$ de la batterie et de son point milieu. La différence entre $E$ et $e$ fournit la force électromotrice $e'$ du second groupe. La comparaison entre $e$ et $e'$ permet de déterminer les grandeurs $e_M$ et $e_m$ égales respectivement à la plus grande et à la plus petite des valeurs $e$ et $e'$. $e_m$ et $e_M$ sont multipliées respectivement par les coefficients $2p$ et $2(p-1)$. Le second de ces produits est ensuite soustrait du premier pour fournir la force électromotrice corrigée $Ec$.

L'étape M2 consiste à calculer le taux de décharge $D\%$ en fonction de $E_c$ en effectuant une interpolation linéaire entre les valeurs minimale et maximale $E_m$ et $E_M$ des forces électromotrices de la batterie lorsque celle-ci est respectivement complètement déchargée et complètement chargée.

L'étape M3 consiste à déterminer en pourcentage la charge maximale $Q_T\%$ en fonction de la température $T$ mesurée. Enfin, l'étape M4 consiste à effectuer la différence entre $Q_T\%$ et $D\%$ pour obtenir l'état de charge $Q\%$.

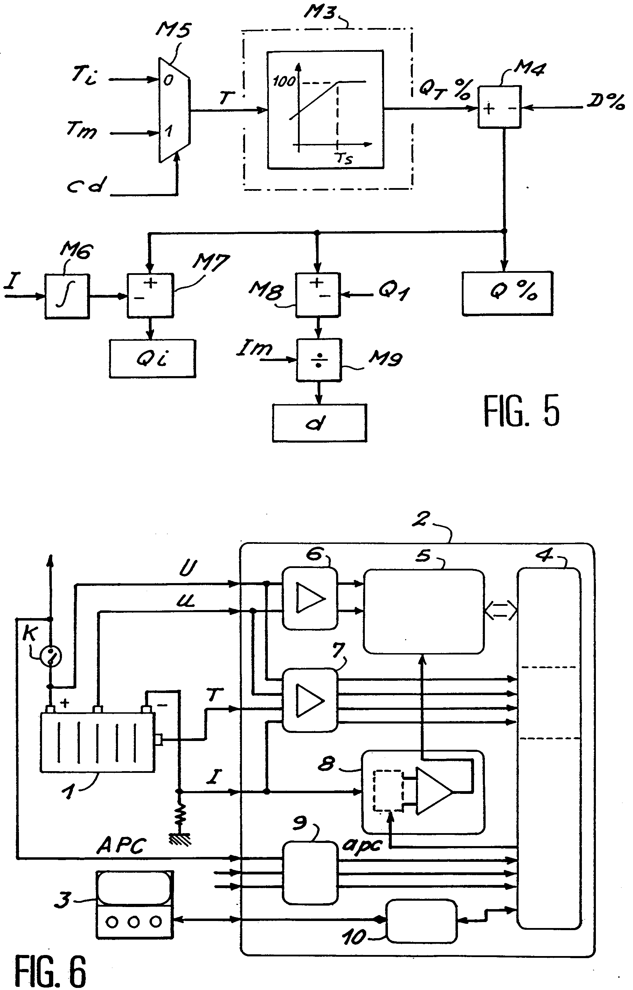

La figure 5 représente une variante du procédé de la figure 4 où l'état de charge $Q\%$ est utilisé pour calculer l'état de charge en cours de fonctionnement du véhicule ainsi que la durée maximale de stationnement. Pour cela, l'étape M3 de mesure de charge maximale est précédée par une étape de sélection M5 pour prendre en compte selon la fonction choisie Cd soit la température instantanée $Ti$ de la batterie, soit une grandeur représentative de la température moyenne la plus probable $Tm$ de la batterie pendant les périodes de repos. Lorsque le véhicule n'est plus au repos, la température instantanée $Ti$ est sélectionnée et une étape M6 calcule une correction correspondant approximativement à l'intégrale par rapport au temps d'une grandeur algébrique représentative du courant $I$ débité par la batterie pendant les périodes de fonctionnement et le résultat de cette intégrale est soustrait à l'étape M7 de la grandeur $Q\%$ pour fournir l'état de charge instantané $Qi$. Pour mieux correspondre à la réalité, cette correction devrait tenir compte du fait que la variation de la charge n'est pas rigoureusement proportionnelle au courant $I$ et dépend également du sens du courant. Ainsi, une meilleure correction peut consister à prendre une grandeur proportionnelle à l'intégrale du courant $I$ avec des coefficients de proportionnalité différents selon que la batterie débite (courant positif) ou est en charge (courant négatif), ces coefficients pouvant être eux mêmes fonction de la température, voire du courant.

Pour obtenir une indication de la durée maximale de stationnement, la température moyenne $Tm$ est sélectionnée et une étape M8 effectue la différence entre $Q\%$ et une valeur $Q1$ représentative de la charge minimale autorisée de la batterie et le résultat de cette différence est divisé à l'étape M9 par une grandeur $Im$ représentative du courant de décharge moyen le plus probable pendant les périodes de repos de façon à fournir l'indication $d$ de la durée maximale de stationnement.

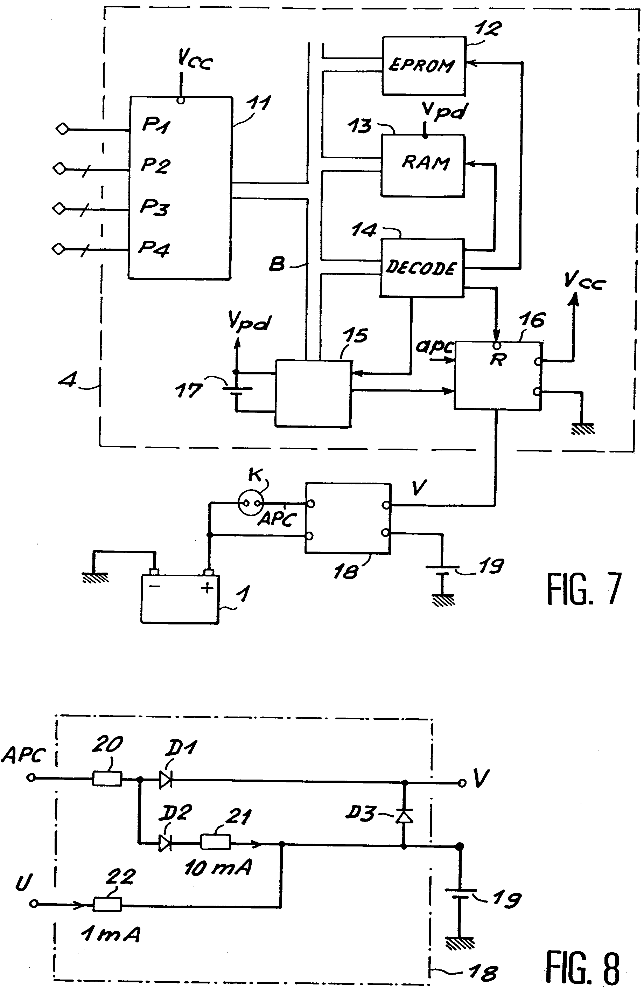

La figure 6 représente un dispositif de mesure pour la mise en oeuvre du procédé décrit précédemment. Le dispositif comprend une unité de contrôle 2 et un dispositif de commande et d'affichage 3 servant à sélectionner les fonctions de l'unité 2 et à visualiser les mesures effectuées par le dispositif. L'unité de contrôle 2 comporte une unité de traitement programmable 4 reliée à l'extérieur par des circuits d'interface 5, 6, 7, 8, 9, 10. Le circuit 5 est un convertisseur analogique numérique relié d'une part aux entrées numériques de l'unité de traitement 4 et d'autre part à la sortie de circuits d'amplification 6 dont les entrées sont reliées aux bornes de la batterie 1 afin de mesurer sa tension $U$ et celle $u$ de son point milieu. Des circuits d'amplification 7 relient les entrées analogiques de l'unité de traitement 4 à un capteur de température placé sur la batterie et à une résistance de mesure du courant $I$ débité. Les circuits 7 sont reliés également aux bornes de la batterie pour fournir à l'unité de traitement 4 les tensions $U$ et $u$ en cours de fonctionnement du véhicule. Le circuit 9 est un circuit d'adaptation de tension reliant l'unité de traitement 4 à l'une des bornes de l'interrupteur d'allumage K. Le dispositif de commande et d'affichage 3 est relié à l'unité de traitement 4 par un circuit d'interface de communication 10.

L'unité de traitement est représentée plus en détail à la figure 7. Elle est constituée d'un micro-contrôleur 11, d'une mémoire de programme 12, d'une mémoire vive 13 et d'un décodeur 14 organisés autour d'un bus B. Une horloge 15 alimentée par une pile 17 commande un circuit de mise en veille 16 dont la sortie fournit la tension d'alimentation Vcc de l'ensemble des composants actifs de l'unité de contrôle 2. Le circuit de mise en veille 16 reçoit une tension V d'un circuit d'alimentation 18 extérieur à l'unité de contrôle 2. Le circuit 18 est relié à la borne positive de la batterie 1, à l'interrupteur K et à une batterie auxiliaire rechargeable 19.

De façon classique, le micro-contrôleur 11 comporte une pluralité de bornes d'entrée et de sortie P1 à P4 lui permettant de communiquer avec les circuits d'interface analogiques ou numériques, notamment le convertisseur analogique numérique 5. Afin de sauvegarder les données, la mémoire vive 13 reçoit en permanence la tension Vpd de la pile 17. Le décodeur 14 est par exemple un réseau logique programmable (PLA) conçu pour fournir divers signaux de sélection en réponse aux adresses et données présentes sur le bus B. En particulier, le décodeur 14 fournit un signal de coupure d'alimentation appliqué à l'entrée R du circuit de mise en veille 16. Le circuit 16 reçoit également un signal logique apc représentatif du niveau de tension à la sortie de l'interrupteur d'allumage K de façon à établir automatiquement l'alimentation des circuits lorsque l'interrupteur K est fermé.

L'unité de contrôle fonctionne de la façon suivante. Lorsque l'interrupteur K est fermé, le circuit de mise en veille 16 alimente normalement les circuits et le micro-contrôleur 11 sélectionne et exécute les programmes contenus dans la mémoire 12 en fonction des commandes fournies par l'unité de commande et d'affichage 3.

Lorsque l'interrupteur K est ouvert, le circuit de mise en veille 16 coupe normalement l'alimentation des circuits tant qu'il ne reçoit aucun signal de commande de l'horloge 15. L'horloge 15 est prévue pour envoyer un tel signal à intervalles de temps réguliers, par exemple toutes les 15 minutes, de façon à rétablir périodiquement l'alimentation. Dans ce cas, le micro-contrôleur 11 interprète l'état bas du niveau de tension APC présent à la sortie de l'interrupteur K comme un ordre d'exécution d'un programme de mesure des paramètres U, u, T, I par l'intermédiaire des circuits d'interface et notamment du convertisseur analogique-numérique 5. L'exécution de ce programme a pour effet d'enregistrer dans la mémoire vive 13 les grandeurs numériques correspondant à ces mesures. Le programme se termine par l'envoi d'une donnée sur le bus B provoquant l'envoi par le décodeur 16 d'un signal sur l'entrée R du circuit de mise en veille 16 provoquant la coupure de l'alimentation.

Lorsque le véhicule n'est plus à l'état de repos, c'est-à-dire lorsque l'interrupteur K est fermé à nouveau, le micro-contrôleur 11 est en mesure d'exécuter les programmes correspondant aux commandes reçues du dispositif d'affichage 3. Ainsi, le micro-contrôleur 11 pourra exécuter un programme pour calculer l'état de charge Q% ou l'état de charge instantané Qi en fonction du courant instantané Ii débité par la batterie ou encore la durée maximum de stationnement d.

La figure 8 représente de façon détaillée le circuit d'alimentation 18. Ce circuit reçoit en entrée la tension U de la borne positive de la batterie et la tension APC à la sortie de l'interrupteur K. Le circuit 18 fournit sur sa borne de sortie la tension V alimentant le circuit de mise en veille 16. L'entrée APC est reliée à la sortie V par l'intermédiaire d'un fusible 20 et d'une diode D1 polarisée dans le sens passant. La diode D1 est branchée en parallèle avec un montage comportant en série une seconde diode D2, une première résistance 21 de limitation de courant et une troisième diode D3, les diodes D2 et D3 étant polarisées dans le sens passant. Le point commun à la résistance 21 et à la diode D3 est relié d'une part à la borne positive de la batterie rechargeable 19 et d'autre part à l'entrée U par l'intermédiaire d'une seconde résistance 22 de limitation de courant. La résistance 21 est dimensionnée de façon à n'autoriser qu'un courant faible, par exemple de l'ordre de 10mA. La résistance 22 est dimensionnée de façon à autoriser un courant plus faible encore, par exemple de l'ordre de 1mA.

Le circuit de la figure 8 fonctionne de la façon suivante. Lorsque l'interrupteur d'allumage K est fermé, l'entrée APC reçoit la tension de la batterie. Cette tension est transmise à la sortie. V par l'intermédiaire de la diode D1. D'autre part, la tension APC sert à recharger la batterie 19 par l'intermédiaire de la diode D2 et de la résistance de limitation 21. Lorsque l'interrupteur K est ouvert, la sortie V est normalement alimentée par l'intermédiaire de la diode D3, par la batterie auxiliaire 19.

L'intérêt de ce montage est d'éviter de solliciter la batterie 1 pendant les périodes de repos du véhicule, ce qui perturberait la mesure de la tension à vide de la batterie.

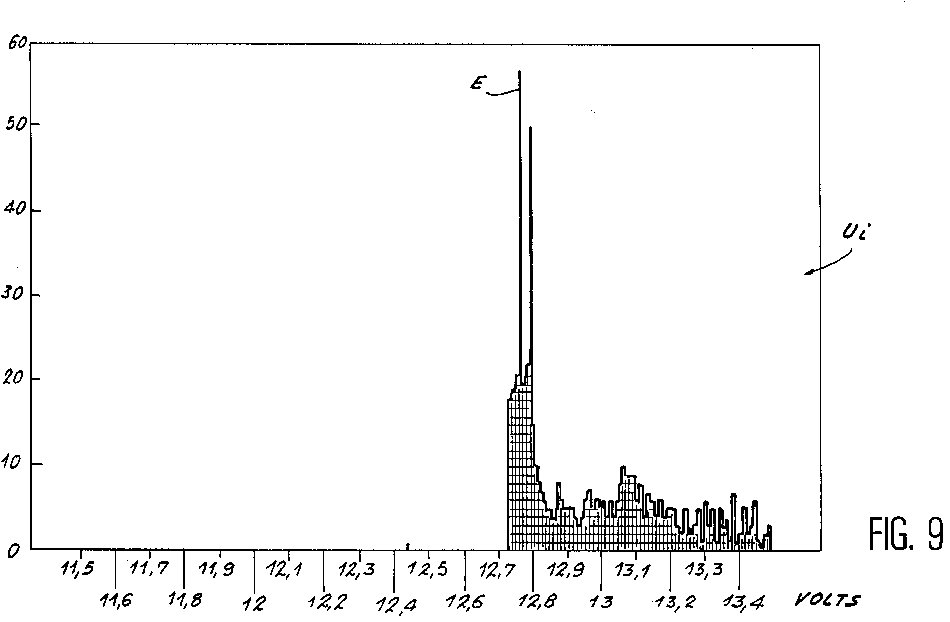

La figure 9 représente un exemple d'histogramme constitué par l'unité de contrôle pendant les périodes de repos. L'histogramme est constitué à partir d'une série de mesures de tension Ui de la batterie. La plage de mesure est subdivisée en plusieurs classes de valeurs de tension définissant des intervalles égaux et adjacents. Ces classes sont représentées en abscisse et le nombre de mesures de tension appartenant à chaque classe est représenté en ordonnée. Ainsi, on pourra évaluer la force électromotrice de la batterie en choisissant une valeur représentative de la classe la plus représentée. Pour améliorer la précision, il est avantageux de choisir comme valeur de force électromotrice la moyenne des valeurs de tension appartenant à cette classe.

Pour avoir une précision suffisante, on prévoira par exemple 200 classes pour des tensions comprises entre 11,5 et 13,5 Volts, soit une plage de 10mV par classe et 200 valeurs de tension mémorisées. Comme les valeurs mémorisées correspondent aux 200 dernières mesures, on constitue un histogramme "glissant" pouvant prendre en compte des mesures effectuées aux cours de plusieurs périodes de repos successives.

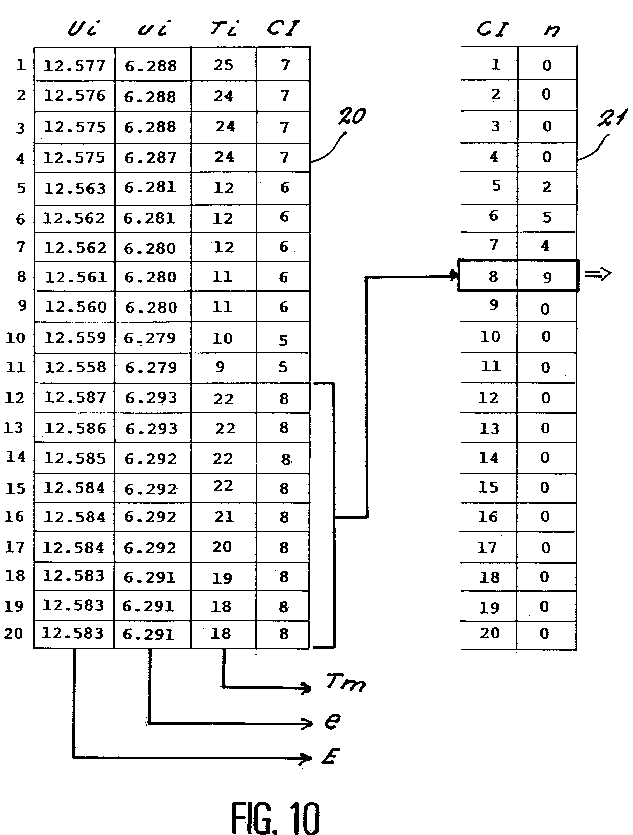

La figure 10 représente l'organisation de l'espace mémoire affecté aux mesures des tensions et des températures. Pour simplifier les explications, l'exemple a été limité à 20 classes et à 20 mesures par paramètre, étant entendu qu'un nombre plus important sera utilisé en réalité. Ainsi, l'espace mémoire se présente sous la forme d'une première table 20 à 20 entrées. Chaque entrée correspond à une mesure et comporte un champ associé à chaque paramètre mesuré, tel que la tension de la batterie U, la tension du point milieu u et la température. Chaque entrée comporte également un champ Cl pour enregistrer la classe à laquelle appartient la tension U mesurée. Le chargement de la table s'effectue selon le mode "premier entré-premier sorti". Ainsi, chaque nouvelle mesure est enregistrée dans l'emplacement de la plus ancienne, cet emplacement étant repéré par un pointeur (non représenté).

La table de mesure est associée à une seconde table 21 dont chaque entrée correspond à l'une des 20 classes Cl et contient le nombre de représentants par classe. Ainsi, lorsqu'une nouvelle mesure est effectuée, la classe correspondant à l'enregistrement le plus ancien est décrémentée d'une unité alors que la classe de la nouvelle mesure est augmentée d'une unité. La consultation de la table 21 permet donc de déterminer immédiatement la classe comportant le plus grand nombre de représentants et de calculer la valeur moyenne des représentants de cette classe à l'aide de la table de gauche. Ainsi, dans l'exemple représenté, la classe n°8 comporte le plus grand nombre de représentants et la force électromotrice E sera calculée en effectuant la moyenne des tensions Ui mesurées qui appartiennent à cette classe. De la même façon, la force électromotrice e et la température moyenne la plus probable sont calculées en faisant la moyenne des tensions ui et températures Ti de cette même classe.

**Revendications**

1) Procédé de mesure de l'état de charge d'une batterie d'accumulateurs (1) à partir de mesures de la force électromotrice (E) et de la température (T) de ladite batterie (1), caractérisé en ce qu'il consiste
   - à déterminer une première fonction (f1) de la température (T) établissant une relation entre ladite température (T) et une valeur de charge maximum ($Q_T$) représentative de la quantité maximale d'électricité emmagasinée à cette température (T) dans la batterie (1),
   - à déterminer une seconde fonction (f2) de la force électromotrice (E) établissant une relation entre ladite force électromotrice (E) et une valeur de décharge (D) représentative de la quantité d'électricité qui doit sortir de la batterie (1) pour la faire passer d'un état de charge maximum ($Q_T$) à un état de charge correspondant à ladite force électromotrice,
   - à mesurer ladite température (T) et ladite force électromotrice (E) et
   - à calculer la différence (Q) entre lesdites première et seconde fonctions (f1, f2) appliquées respectivement auxdites température (T) et force électromotrice (E) mesurées.

2) Procédé de mesure selon la revendication 1, caractérisé en ce que ladite première fonction (f1) est une fonction linéaire croissante de la température (T) lorsque celle-ci est inférieure à une valeur de seuil déterminée (Ts) et une fonction constante lorsque ladite température (T) est supérieure à ladite valeur de seuil (Ts).

3) Procédé de mesure selon la revendication 2, caractérisé en ce que ladite seconde fonction (f2) est une fonction linéaire décroissante de ladite force électromotrice (E).

4) Procédé de mesure selon la revendication 3, caractérisé en ce que lesdites première et seconde fonctions (f1, f2) et ladite différence (Q) définissent des quantités d'électricité rapportées à la quantité maximum d'électricité ($Q_M$) pouvant être emmagasinée dans la batterie (1).

5) Procédé de mesure selon l'une des revendications 1 à 4, caractérisé en ce que ladite batterie étant installée dans un véhicule automobile, ladite mesure de force électromotrice (E) est effectuée à partir de mesures de tension (Ui) aux bornes de la batterie (1) pendant les périodes de repos du véhicule.

6) Procédé selon la revendication 5, caractérisé en ce que lesdites mesures de tension (Ui) sont effectuées à des instants successifs puis enregistrées sous forme de grandeurs numériques dans un espace mémoire (13) adressé selon le mode "premier entré-premier sorti" et en ce que lesdites grandeurs numériques enregistrées sont utilisées pour calculer par une méthode statistique une valeur représentative de ladite force électromotrice (E).

7) Procédé de mesure selon la revendication 6, caractérisé en ce qu'il consiste à définir une pluralité de classes (Cl) de valeur de tension au moyen d'intervalles de grandeur numérique égaux et adjacents, chaque classes (Cl) étant associées à une valeur numérique de tension et en ce que ladite valeur représentative de ladite force électromotrice (E) est la valeur numérique de tension associées à la classe (Cl) la plus représentée.

8) Procédé selon la revendication 7, caractérisé en ce que ladite valeur numérique de tension associée à la classe (Cl) la plus représentée est la valeur moyenne des grandeurs numériques des tensions appartenant à ladite classe (Cl) la plus représentée.

**9)** Procédé de mesure selon l'une des revendications 1 à 8, caractérisé en ce que ladite batterie (1) étant organisée en deux groupes d'accumulateurs montés en série, on calcule une force électromotrice corrigée (Ec) qui serait celle d'un état fictif (1c) de la batterie (1) dont chaque accumulateur aurait une force électromotrice élémentaire minimale, ladite force électromotrice élémentaire minimale étant celle d'un accumulateur particulier d'un second état fictif où les groupes ont respectivement les mêmes forces électromotrices moyennes que celles des groupes de l'état réel et dont ledit accumulateur particulier aurait ladite force électromotrice minimale alors que les autres accumulateurs ont la même force électromotrice et en ce que ladite force électromotrice corrigée (Ec) est appliquée à ladite seconde fonction (f2) pour calculer ladite différence (Q).

**10)** Procédé de mesure selon la revendication 9, caractérisé en ce que lesdits groupes comportant le même nombre (p) d'éléments, ladite force électromotrice corrigée (Ec) est calculée en fonction des forces électromotrices (E,e) de la batterie (1) et d'un de ses groupes selon la formule :

$$Ec = 2p \, Inf(e, E - e) - 2(p - 1) \, Sup(e, E - e),$$

où :

Ec est la valeur de la force électromotrice corrigée, e est la valeur de la force électromotrice du groupe, p est le nombre d'éléments par groupe,
$Inf(e, E-e)$ est la plus petite des valeurs e et E-e,
$Sup(e, E-e)$ est la plus grande des valeurs e et E-e.

**11)** Procédé de mesure selon la revendication 10, caractérisé en ce que ladite batterie (1) étant installée dans un véhicule automobile, lesdites mesures de forces électromotrices (E,e) de la batterie (1) et dudit groupe sont effectuées à partir de mesures de tension (Ui) aux bornes de la batterie (1) et de mesures de tension (ui) au point milieu de la batterie (1) pendant les périodes de repos du véhicule.

**12)** Procédé de mesure selon l'une des revendications 5 à 11, caractérisé en ce que, lorsque le véhicule est en fonctionnement, on soustrait à ladite différence (Q) une valeur représentative de l'intégrale par rapport au temps du courant (I) en valeur algébrique débité par la batterie.

**13)** Utilisation du procédé de mesure selon l'une des revendications 1 à 11 pour évaluer la durée maximale (d) de stationnement d'un véhicule muni de ladite batterie (1), caractérisée en ce qu'on évalue la température moyenne (Tm) et le courant de décharge moyen (Im) le plus probable de la batterie (1) pendant les périodes de repos du véhicule et en ce que la durée maximale (d) est calculée selon la formule $d=(Q-Q_1)/Im$, où :

d est la durée maximale de stationnement,
Q est la charge de la batterie à la température moyenne la plus probable,

$Q_1$ est la charge minimale de la batterie,
Im est le courant de décharge moyen le plus probable pendant les périodes de repos.

**14)** Dispositif de mesure de l'état de charge d'une batterie installée dans un véhicule automobile pour la mise en oeuvre du procédé selon l'une des revendications 1 à 11, ledit dispositif comportant une unité de contrôle (2) et un dispositif d'affichage (3) reliés entre eux, ladite unité de contrôle (2) comprenant :

- un capteur de température (7) pour mesurer la température (T) de la batterie,
- au moins un capteur de tension (6) relié aux bornes de la batterie (1),
- un capteur d'état (9) pour détecter l'état de repos du véhicule,
- une unité de traitement (4) programmable communiquant avec lesdits capteurs (6, 7, 9) et dispositif d'affichage (3),
ledit dispositif de mesure étant caractérisé en ce que ladite unité de traitement (4) est programmée de façon à enregistrer les signaux fournis par lesdits capteurs de tension (6) pendant les périodes de repos détectées en réponse aux signaux fournis par ledit capteur d'état (9) et pour calculer :
- une première fonction (f1) de ladite température (T), ladite première fonction (f1) établissant une relation entre ladite température (T) et une valeur de charge maximum $(Q_T)$ représentative de la quantité maximale d'électricité emmagasinée à cette température (T) dans la batterie (1),
- une seconde fonction (f2) desdits signaux enregistrés, ladite seconde fonction (f2) établissant une relation entre la force électromotrice (E) et une valeur de décharge (D) représentative de la quantité d'électricité qui doit sortir de la batterie (1) pour la faire passer d'un état de charge maximum $(Q_T)$ à un état de charge correspondant à ladite force électromotrice et,
- la différence (Q) entre lesdites première et seconde fonctions (f1, f2).

**15)** Dispositif de mesure selon la revendication 14, caractérisé en ce que l'unité de contrôle (2) étant normalement alimentée par une tension d'alimentation fournie par la batterie (1), elle comporte des moyens (14, 15, 16,17) pour couper et établir ladite tension d'alimentation pendant les périodes de repos, en ce que l'établissement de ladite tension d'alimentation est provoqué par un signal d'horloge et en ce que la coupure de ladite tension d'alimentation est provoquée par la fin d'une opération de mesure de tension.

**16)** Dispositif de mesure selon l'une des revendications 14 ou 15, caractérisé en ce qu'il comporte un capteur (8) communiquant avec l'unité de traitement (4) pour mesurer le courant (I) débité par la batterie (1), et en ce que l'unité de traitement (4) est programmée pour soustraire à ladite différence (Q) une valeur représentative de l'intégrale par rapport au temps du courant (I) en valeur algébrique débité par la batterie lorsque le véhicule n'est pas au repos.

**17)** Dispositif de mesure selon la revendication 16, caractérisé en ce que ladite unité de traitement (4) est en outre programmée pour enregistrer pendant les périodes de repos des valeurs représentatives des courants mesurés par ledit capteur (8) de courant (I) et des valeurs représentatives des températures mesurées par ledit capteur de température (7), pour calculer respectivement les valeurs moyennes les plus probables desdites valeurs de courant (I) et de température (T) enregistrées et pour calculer une durée maximale (d) de stationnement du véhicule selon la formule $d=(Q-Q_1)/Im$, où:

d est la durée maximale de stationnement,

Q est la charge de la batterie à la température moyenne la plus probable,

$Q_1$ est la charge minimale de la batterie,

Im est le courant moyen le plus probable.

FIG. 1

FIG. 2

FIG. 3

10

FIG. 4

EP 0 596 789 A1

FIG. 5

FIG. 6

FIG. 7

FIG. 8

FIG. 9

| | $Ui$ | $ui$ | $Ti$ | $CI$ | | $CI$ | $n$ |
|---|---|---|---|---|---|---|---|
| 1 | 12.577 | 6.288 | 25 | 7 | | 1 | 0 |
| 2 | 12.576 | 6.288 | 24 | 7 | | 2 | 0 |
| 3 | 12.575 | 6.288 | 24 | 7 | | 3 | 0 |
| 4 | 12.575 | 6.287 | 24 | 7 | | 4 | 0 |
| 5 | 12.563 | 6.281 | 12 | 6 | | 5 | 2 |
| 6 | 12.562 | 6.281 | 12 | 6 | | 6 | 5 |
| 7 | 12.562 | 6.280 | 12 | 6 | | 7 | 4 |
| 8 | 12.561 | 6.280 | 11 | 6 | | 8 | 9 |
| 9 | 12.560 | 6.280 | 11 | 6 | | 9 | 0 |
| 10 | 12.559 | 6.279 | 10 | 5 | | 10 | 0 |
| 11 | 12.558 | 6.279 | 9 | 5 | | 11 | 0 |
| 12 | 12.587 | 6.293 | 22 | 8 | | 12 | 0 |
| 13 | 12.586 | 6.293 | 22 | 8 | | 13 | 0 |
| 14 | 12.585 | 6.292 | 22 | 8 | | 14 | 0 |
| 15 | 12.584 | 6.292 | 22 | 8 | | 15 | 0 |
| 16 | 12.584 | 6.292 | 21 | 8 | | 16 | 0 |
| 17 | 12.584 | 6.292 | 20 | 8 | | 17 | 0 |
| 18 | 12.583 | 6.291 | 19 | 8 | | 18 | 0 |
| 19 | 12.583 | 6.291 | 18 | 8 | | 19 | 0 |
| 20 | 12.583 | 6.291 | 18 | 8 | | 20 | 0 |

20

21

$Tm$

$e$

$E$

# FIG. 10

# EP 0 596 789 A1

**Office européen des brevets**

## RAPPORT DE RECHERCHE EUROPEENNE

Numero de la demande

EP    93 40 2684
PAGE1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 206 503 (BL TECHNOLOGY)<br>* abrégé; figure 2 *<br>--- | 1,14 | G01R31/36 |
| Y | ELEKTROTECHNIK UND MASCHINENBAU<br>vol. 102, no. 2, Février 1985, WIEN AT<br>pages 82 - 87<br>W.SCHLEUTER ET AL. 'Ein Gerät zur Ermittlung des Ladezustandes von Bleiakkumulatoren'<br>* page 83, colonne de droite, alinéa 2; figure 2 *<br>* page 84, colonne de gauche, alinéa 3 - colonne de droite, alinéa 3; figure 3 *<br>* page 85, colonne de droite, alinéa 2; figure 5 *<br>* page 85, colonne de droite, dernier alinéa  - page 86, colonne de gauche, alinéa 4; figure 7 *<br>--- | 1,14 | |
| A | EP-A-0 090 699 (RENAULT)<br>* abrégé; revendications 1-5; figures 1-3 *<br>--- | 1 | **DOMAINES TECHNIQUES RECHERCHES (Int. Cl.5)** |
| A | EP-A-0 448 755 (ANTON/BAUER)<br>* abrégé; figure 2 *<br>--- | 9,11,15 | G01R<br>H01M<br>B60L |
| A | GB-A-2 148 518 (LUCAS)<br>* page 2, ligne 10 - ligne 14; figures 4-6 *<br>--- | 9 | |
| A | FR-A-2 627 593 (MITSUBISHI DENKI)<br>* revendications 1-3 *<br>--- | 5,14 | |
| A | US-A-5 130 659 (J.M.SLOAN)<br>* abrégé; figures 1,5 *<br>* colonne 1, ligne 49 - ligne 64 *<br>---<br>-/-- | 13,14,17 | |

Le présent rapport a été établi pour toutes les revendications

| Lieu de la recherche | Date d'achèvement de la recherche | Examinateur |
|---|---|---|
| BERLIN | 11 JANVIER 1994 | FRITZ S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)

16

EP 0 596 789 A1

Office européen
des brevets

**RAPPORT DE RECHERCHE EUROPEENNE**

Numero de la demande

EP    93 40 2684
PAGE2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 280 916 (ELEKTRON-BREMEN)<br>* abrégé; revendications 1,2,7,12; figures 1-7 *<br>* colonne 6, ligne 23 - ligne 29 *<br><br>----- | 6-8 | |
| | | | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| BERLIN | 11 JANVIER 1994 | FRITZ S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)